# EUROPÄISCHE PATENTSCHRIFT

(11) **EP 2 509 214 B1**
(45) Veröffentlichungstag und Bekanntmachung des Hinweises auf die Patenterteilung: **22.02.2023**
(21) Anmeldenummer: 12002381.7
(22) Anmeldetag: 31.03.2012
(51) Int. Cl.: H02P 29/02, H02P 29/024, G01R 31/34, H02P 29/032

(54) **Verfahren zur Inbetriebnahme einer elektronischen Ansteuerschaltung eines elektrischen Motors und Schaltungsanordnung hierzu**
Method for initiating an electronic control circuit of an electric motor and circuit assembly for same
Procédé de mise en service du commutateur de commande électronique d'un moteur électrique et agencement de commutation correspondant

(30) Priorität: 04.04.2011 DE 102011015977
(43) Veröffentlichungstag der Anmeldung: 10.10.2012
(73) Patentinhaber: Andreas Stihl AG & Co. KG, 71336 Waiblingen (DE)
(72) Erfinder: Wichert, René, 73568 Durlangen (DE); Liebhard, Gernot, 71332 Waiblingen (DE)
(74) Vertreter: Wasmuth, Rolf

(56) Entgegenhaltungen:
- EP-A1- 2 112 521
- WO-A1-97/32220
- US-A1- 2004 085 087

## Beschreibung

Die Erfindung betrifft ein Verfahren zur Inbetriebnahme einer elektronischen Ansteuerschaltung für die Statorwicklungen eines elektrischen Motors.

Es ist bekannt, einen elektrischen Motor wie z. B. einen elektronisch kommutierten EC-Motor oder dgl. über eine Ansteuerschaltung bzw. einen Inverter mit einer Gleichspannungsquelle zu verbinden, wobei die Spulenenden der Statorwicklungen über je einen Leistungsschalter mit der einen Anschlussklemme der Spannungsquelle und über je einen weiteren Leistungsschalter mit der anderen Anschlussklemme der Spannungsquelle verbunden ist. Die Steuereinheit schaltet die sechs Leistungsschalter derart, dass sich in dem Stator des Motors ein Drehfeld für den Rotor ergibt und diesen mitnimmt.

In handgetragenen, elektrischen Arbeitsgeräten werden Akkublocks hoher Leistungsdichte verwendet, so z. B. Akkublocks mit chemisch auf Lithium basierenden Zellen. So sind in einem Akkublock mehrere Lithium-Ionen-, Lithium-Polymer- oder dgl. Zellen miteinander verschaltet, um einen Akkublock mit hoher Ausgangsspannung und großer Kapazität zur Verfügung zu stellen. Wird ein derartiger Akkublock an eine defekte Ansteuerschaltung angeschlossen, können bereits beim Anschließen oder beim Einschalten des Motors hohe Ströme fließen, die die elektronische Schaltung ebenso wie den Motor schädigen können. Daher ist es zweckmäßig, die ordnungsgemäße Funktion der Elektronik vor Einschalten der Akkuspannung zu überprüfen um die Elektronik selbst und/oder den Motor zu schützen.

Aus der WO 97/32220 A1 ist ein Verfahren zur Inbetriebnahme einer elektronischen Ansteuerschaltung für die Wicklungen eines elektrischen Motors mit einer an eine

Spannungsquelle angeschlossenen Steuereinheit bekannt. Ferner ist ein über ein Systemschaltelement mit den Anschlussklemmen der Spannungsquelle verbundener Kondensator eines Filterkreises zur Stromglättung vorgesehen, der parallel zur Ansteuerschaltung liegt. Das Systemschaltelement wird von einer Betriebsschaltung angesteuert, wobei zur Inbetriebnahme des Motors das Systemschaltelement geöffnet ist und der Kondensator über einen Widerstand parallel zum geöffneten Systemschaltelement geladen wird. Eine Funktionsprüfung der Ansteuerschaltung erfolgt bei geöffnetem Systemschaltelement mit dem, über den Widerstand geladenen, Kondensator. Der Widerstand liegt permanent parallel zum Systemschaltelement.

Der Erfindung liegt die Aufgabe zugrunde, ein Verfahren zur Inbetriebnahme einer elektronischen Ansteuerschaltung für die Statorwicklungen eines elektrischen Motors anzugeben, bei dem vor Inbetriebnahme des Motors mit einfachen Mitteln die Funktionsfähigkeit der wesentlichen Schaltungselemente überprüft wird, ohne dass die Ansteuerschaltung mit der Spannungsversorgung verbunden ist.

Die Aufgabe wird erfindungsgemäß nach den Merkmalen des Anspruchs 1 gelöst.

Der auf der Seite der Ansteuerschaltung an deren Eingangsklemmen angeordnete Kondensator wird so ausgelegt, dass er zum Löschen von Spannungsspitzen und zusätzlich auch als Energiezwischenspeicher dient. Dieser Energiezwischenspeicher wird durch Schließen des Systemschaltelementes von der Spannungsquelle aufgeladen, um dann - wenn der Kondensator geladen ist - das Systemschaltelement wieder zu öffnen und somit die Spannungsquelle von der Ansteuerschaltung wieder zu trennen. Nun kann - nur mit der im Kondensator gespeicherten Ladung - ein Prüfzyklus ausgeführt werden, wobei während des Prüfzyklus die Ansteuerschaltung ausschließlich von dem Kondensator gespeist ist. Dies hat den Vorteil, dass bei einem Systemkurzschluss in der Ansteuerschaltung die im Kurzschlussfall fließende Energie durch die im Kondensator gespeicherte Ladung begrenzt ist. Ein Kurzschlussstrom ist abhängig von der Kapazität des verwendeten Kondensators zeitlich und in der Höhe begrenzt. Damit können Schädigungen der Elektronik ebenso vermieden werden, wie Schädigungen am Motor selbst oder am Akkublock.

Vorteilhaft wird von der Steuereinheit die Kondensatorspannung überwacht, die ein Indikator für eine fehlerfreie oder fehlerbehaftete Funktion des Systems ist. So wird sich als Antwort auf die Prüfung während der Ausführung eines Prüfschrittes die Kondensatorspannung ändern oder konstant bleiben; so kann in Abhängigkeit des durchgeführten Prüfschrittes und des Verhaltens der Kondensatorspannung bewertet werden, ob der Prüfschritt fehlerfrei abgelaufen ist oder fehlerbehaftet war.

So kann nach dem Öffnen des Systemschaltelementes in einem Prüfschritt der Kondensator mit einer Last verbunden werden, um festzustellen, ob als Antwort die Kondensatorspannung sinkt oder gleich bleibt. Bei sinkender Kondensatorspannung hat der Systemschalter ordnungsgemäß geöffnet, ist also fehlerfrei. Bleibt hingegen die Kondensatorspannung etwa konstant, ist das ein Indiz dafür, dass das Systemschaltelement nicht ordnungsgemäß geöffnet hat und der Kondensator daher permanent aus der Spannungsquelle nachgeladen werden kann. Das Systemschaltelement ist fehlerbehaftet, da es nicht ordnungsgemäß geöffnet hat.

In einem weiteren Prüfschritt wird ein Leistungsschalter eines Zweiges der Ansteuerschaltung geschlossen, wobei der zweite Leistungsschalter in diesem Zweig offen bleibt. Da über die beiden geschlossenen Leistungsschalter eines Zweiges die Eingangsklemmen der Ansteuerschaltung miteinander kurzgeschlossen werden, würde sich - hat der offene Leistungsschalter Durchgang - der Kondensator entladen, die Kondensatorspannung somit sinken. Eine absinkende Kondensatorspannung nach Schließen nur eines Leistungsschalters in einem Zweig der Ansteuerschaltung deutet somit auf einen fehlerbehafteten offenen anderen Leistungsschalter im Zweig hin. Bleibt hingegen die Kondensatorspannung konstant, ist der offene Leistungsschalter fehlerfrei, da er den Zweig ordnungsgemäß offen hält.

Da es für diesen Prüfschritt ausreichend ist festzustellen, ob einer der Leistungsschalter der vorhandenen drei Zweige fehlerbehaftet ist, ist es zweckmäßig, dass alle an einer Anschlussklemme angeschlossenen Leistungsschalter gleichzeitig in einem Prüfschritt geschlossen werden. So können alle Leistungsschalter der High-Side gleichzeitig geschlossen werden, um zu überprüfen, ob die offenen Leistungsschalter der Low-Side fehlerfrei arbeiten. Entsprechend werden in einem weiteren Prüfschritt alle Leistungsschalter der Low-Side geschlossen und die Leistungsschalter der High-Side offen geschaltet. Bleibt die Kondensatorspannung weitgehend konstant, öffnen die Leistungsschalter der High-Side fehlerfrei.

Diese ersten Prüfschritte bilden einen Grundprüfzyklus, nach dessen fehlerfreiem Durchlaufen sicher ist, dass sowohl das Systemschaltelement als auch die Leistungsschalter der Ansteuerschaltung ordnungsgemäß öffnen. Nun kann in einem erweiterten Prüfzyklus eine von der Kondensatorspannung abgeleitete Prüfspannung auf je eine Statorwicklung ohne Erzeugung eines Drehmomentes aufgeschaltet werden und der über der Zeit anwachsende Strom bzw. der Stromverlauf ausgewertet werden. So wird in einer bevorzugten Ausführungsform die Steigung des Stromanstiegs über der Zeit ermittelt und nach der Gleichung L=U_{L}^{∗}di/dt die Induktivität der bestromten Statorwicklungen berechnet. Um einen Offset zu eliminieren ist vorgesehen, während der Bestromung zwischen zwei Knotenpunkten mehrfach die Steigung des Stromanstiegs zu ermitteln und die Induktivität zu berechnen. Aus den erhaltenen Werten wird dann der Mittelwert der Induktivität bestimmt.

Es kann zweckmäßig sein, die Lage der Stromkurve zu überwachen. Liegt eine sich über der Zeit ergebende anwachsende Stromkurve innerhalb eines vorgegebenen Korridors, ist die angeschaltete Statorwicklung fehlerfrei angeschlossen. Läuft hingegen die Stromkurve aus dem Korridor heraus, ist der Anschluss der Statorwicklung fehlerhaft.

Zweckmäßig ist die in einem Prüfschritt aufgeschaltete Spannung nicht die Kondensatorspannung selbst, sondern eine Prüfspannung, die ein aus der Kondensatorspannung abgeleitetes pulsweitenmoduliertes Signal ist. Die Pulsweite wird so eingestellt, dass sich eine für den Prüfschritt geeignete mittlere, effektive Prüfspannung ergibt. Damit kann eine vom Ladezustand des Kondensators unabhängige, gleiche mittlere effektive Prüfspannung bereitgestellt werden. Um zu Beginn der Prüfung immer von einem definierten Ausgangszustand auszugehen ist vorgesehen, dass die Steuereinheit vor dem Schließen des Systemschaltelementes die Ansteuerschaltung in eine Ausgangsstellung schaltet, also ein Reset ausführt.

Die Merkmale der Erfindung ergeben sich aus den Ansprüchen. Die Beschreibung und die Figuren beschreiben nachfolgend im Einzelnen ein Ausführungsbeispiel.

Es zeigen:
- Fig. 1: in schematischer Darstellung eine Schaltungsanordnung mit einer elektronischen Ansteuerschaltung zum Ansteuern eines elektrischen Motors,
- Fig. 2: die Schaltungsanordnung nach Fig. 1 in einem ersten Prüfschritt eines Prüfzyklus zum Testen des Systemschaltelementes,
- Fig. 3: die Schaltungsanordnung nach Fig. 1 in einem zweiten Prüfschritt zum Testen der Offenstellung der High-Side-Leistungsschalter,
- Fig. 4: die Schaltungsanordnung nach Fig. 1 in einem dritten Prüfschritt zum Testen der Offenstellung der Low-Side-Leistungsschalter,
- Fig. 5: die Schaltungsanordnung in einem vierten Prüfschritt eines Prüfzyklus zum Testen des ordnungsgemäßen Anschlusses einer ersten Statorwicklung,
- Fig. 6 bis 10: die Schaltungsanordnung nach Fig. 5 in weiteren Prüfschritten eines Prüfzyklus zum Testen des ordnungsgemäßen Anschlusses der weiteren Statorwicklungen in allen möglichen Betriebszuständen,
- Fig. 11: in schematischer Darstellung den Verlauf des Stroms in einer Wicklung aufgetragen über der Zeit nach Anlegen einer Prüfspannung.

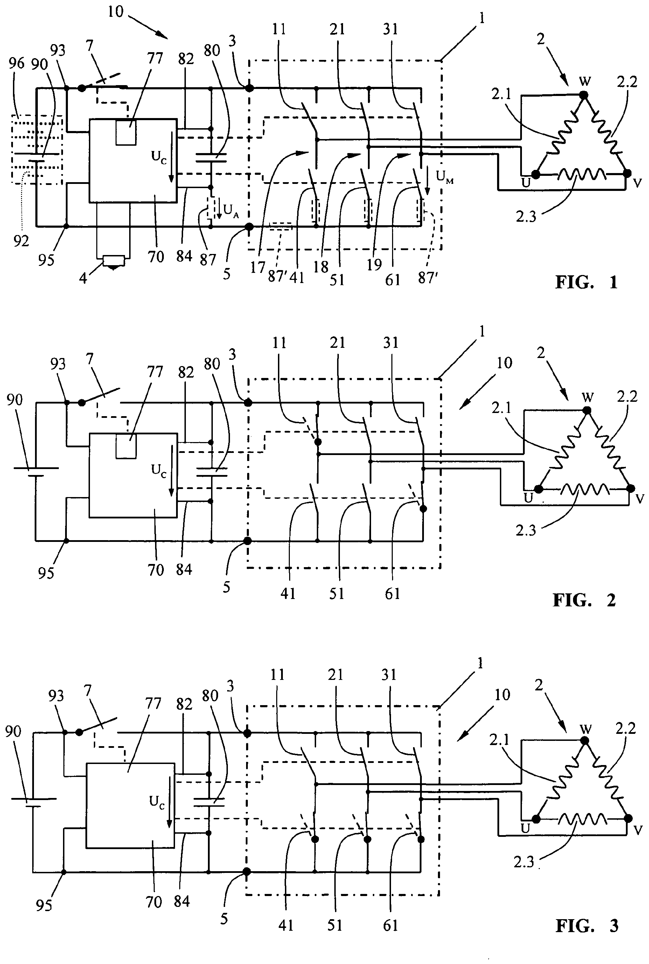

Die in Fig. 1 schematisch dargestellte Schaltungsanordnung 10 dient zur Inbetriebnahme einer elektronischen Ansteuerschaltung 1 für die Statorwicklungen 2.1, 2.2 und 2.3 eines elektrischen Motors 2. Im gezeigten Ausführungsbeispiel ist der elektrische Motor ein elektronisch kommutierter Motor, ein sogenannten EC-Motor mit im Dreieck geschalteten Wicklungen 2.1, 2.2 und 2.3, insbesondere die Wicklungen des Stators. Alternativ ist eine Sternschaltung der Wicklungen möglich. Die Ansteuerschaltung 1 eignet sich in entsprechender Weise auch zum Ansteuern von Gleichstrommotoren, Synchronmotoren, Asynchronmotoren oder dgl..

Die Ansteuerschaltung 1 ist mit ihren Eingangsklemmen 3 und 5 an den Anschlussklemmen 93 und 95 einer Spannungsquelle 90 angeschlossen. Die Spannungsquelle 90 ist eine Gleichspannungsquelle, deren Spannung als pulsweitenmoduliertes Signal von der Ansteuerschaltung 1 weitergegeben wird. Parallel zur Ansteuerschaltung 1 liegt an deren Eingangsklemmen 3 und 5 ein Kondensator 80 zum Löschen von Spannungsspitzen, insbesondere ein Elektrolytkondensator. Der Kondensator 80 bildet ferner einen Energiespeicher für einen Prüfbetrieb. Zwischen der Eingangsklemme 3 und der Anschlussklemme 93 ist ein Systemschaltelement 7 vorgesehen, über welches die Gesamtanordnung an die Spannung der Spannungsquelle 90 anschaltbar oder von dieser zu trennen ist. Der Kondensator 80 liegt auf der Seite der Ansteuerschaltung 1, d. h., der Kondensator 80 ist über das Systemschaltelement 7 an die Anschlussklemme 93 angeschlossen.

Im gezeigten Ausführungsbeispiel ist die Spannungsquelle 90 eine Gleichspannungsquelle, insbesondere ein Akkublock 96 aus bevorzugt in Reihe geschalteten Einzelzellen 92. Die Einzelzellen 92 sind insbesondere chemisch auf Lithium basierende Zellen, so z. B. Lithium-Ionen-, Lithium-Polymer-, Lithium-Eisen- oder dgl. Zellen. Durch die Reihenschaltung kann eine Akkublockspannung von etwa 18 Volt bis 80 Volt, insbesondere etwa 36 Volt zur Verfügung gestellt werden.

Das Systemschaltelement 7 der Schaltungsanordnung 10 ist von einer Betriebsschaltung 77 gesteuert, die Teil einer Steuereinheit 70 sein kann oder in diese integriert ist. An der Steuereinheit 70 ist ein Betriebsschalter 4 angeschlossen, der von einem Benutzer zur Inbetriebnahme des Motors 2 gedrückt wird.

Die Kondensatorspannung U_{C} des Kondensators 80 wird über Messleitungen 82, 84 abgegriffen, so dass der Steuereinheit 70 jederzeit die Kondensatorspannung U_{C} zur Auswertung zur Verfügung steht.

Im gezeigten Ausfiihrungsbeispiel nach Fig. 1 kann ferner ein Shunt-Widerstand 87 im Kondensatorzweig vorgesehen sein, dessen Spannung U_{A} über die Messleitung 84 gegenüber Masse von der Steuereinheit 70 erfasst wird. Über den Shunt-Widerstand 87 kann der Lade- und Entladestrom des Kondensators erfasst werden. Entsprechend kann ein Shunt-Widerstand 87' im Zweig eines Schaltelementes oder im Zweig der Eingangsklemme 5 vorgesehen werden, wie in Fig. 1 strichliert angedeutet. Durch Erfassen der am Innenwiderstand eines geschlossenen Leistungsschalters abfallenden Spannung U_{M} kann ebenso der fließende Strom bzw. der Stromverlauf über der Zeit in dem Zweig erfasst werden.

Die Steuereinheit 70 dient der Steuerung von Leistungsschaltern 11, 21, 31, 41, 51, 61, über welche die Knotenpunkte U, V, W der Dreiecksschaltung der Statorwicklungen 2.1, 2.2, 2.3 an die Spannungsquelle 90 angeschlossen werden. Jeder Knotenpunkt ist über einen Leistungsschalter 11, 21, 31 mit der einen Anschlussklemme 93 der Spannungsquelle 90 verbunden, die im gezeigten Ausführungsbeispiel die High-Side bildet. Entsprechend ist jeder Knotenpunkt U, V, W über eine Leistungsschaltung 41, 51, 61 mit der Anschlussklemme 95 verbunden, die die Low-Side der Spannungsversorgung bildet. Da jeweils zwei Spulenenden der Statorwicklungen in den Knotenpunkten U, V, W verbunden sind, ist über die Leistungsschalter 11 bis 61 jedes Spulenende sowohl mit der High-Side der Spannungsversorgung (Anschlussklemme 93) als auch mit der Low-Side der Spannungsversorgung (Anschlussklemme 95) verbunden. Die Leistungsschalter werden von der Steuereinheit 70 angesteuert, was durch strichlierte Linien in Fig. 1 angedeutet ist. Die Anordnung der Leistungsschalter erfolgt in parallelen Zweigen, die die Eingangsklemmen 3, 5 miteinander verbinden. In einem ersten Zweig 17 liegen die Leistungsschalter 11 und 41 in Reihe; in einem zweiten Zweig 18 liegen die Leistungsschalter 21 und 51 in Reihe und in einem dritten Zweig 19 liegen die Leistungsschalter 31 und 61 in Reihe.

Zur Inbetriebnahme des Motors 2 drückt der Benutzer z. B. den Betriebsschalter 4, so dass die Steuereinheit 70 ein Anforderungssignal zum Einschalten des Motors 2 erhält. Bevor der Motor 2 in Betrieb genommen wird, wird von der Steuereinheit 70 ein Prüfzyklus gestartet, der die ordnungsgemäße Funktion sowohl des Systemschaltelementes 7 als auch der Leistungsschalter 11 bis 61 überprüft. Ist die Überprüfung des Systemschaltelementes und der Leistungsschalter abgeschlossen, wird der ordnungsgemäße Zustand der Statorwicklungen und deren Verschaltung überprüft. Erst wenn diese Überprüfung ebenfalls positiv abgeschlossen wurde, wird durch entsprechende Bestromung der Statorwicklungen 2.1, 2.2 und 2.3 der Motor 2 in Betrieb genommen.

Die einzelnen Prüfschritte des Prüfzyklus laufen wie folgt ab:
Erhält die Steuereinheit 70 über den Betriebsschalter 4 ein Anforderungssignal zur Inbetriebnahme des Motors 2, wird zunächst die Ansteuerschaltung 1 in eine Ausgangsstellung gebracht, also resettet. Alle Leistungsschalter 11 bis 61 sind geöffnet. Das Systemschaltelement 7 steht offen, wie in Fig. 1 strichliert dargestellt. Da die Steuereinheit 70 unmittelbar mit den Anschlussklemmen 93 und 95 der Spannungsquelle 90 verbunden ist, ist die Steuereinheit 70 auch dann betriebsbereit, wenn das Systemschaltelement 7 offen ist.

Nachdem die Ansteuerschaltung 1 resettet wurde, wird über die Betriebsschaltung 77 das Systemschaltelement 7 für einen vorgegebenen Zeitraum geschlossen, wodurch der Kondensator 80 aufgeladen wird. Da alle Leistungsschalter 11 bis 61 offen stehen, fließt durch den Motor 2 kein Strom.

Die Aufladung des Kondensators 80 kann zeitgesteuert erfolgen, d. h., die Betriebsschaltung 77 schließt das Systemschaltelement 7 für eine vorgegebene Zeitspanne und öffnet dieses dann wieder. Es kann auch zweckmäßig sein, den Spannungsanstieg der Kondensatorspannung U_{C} durch die Steuereinheit 70 zu überwachen und nach Erreichen eines vorgegebenen Schwellwertes der Kondensatorspannung Uc über die Betriebsschaltung 77 das Systemschaltelement 7 wieder zu öffnen. Nachdem der Kondensator 80 geladen ist, steht für einen folgenden Prüfzyklus ausreichend elektrische Energie zur Verfügung, die vom Kondensator 80 über die Eingangsklemmen 3 und 5 eingespeist wird. Es kann zweckmäßig sein, nach Abarbeiten eines ersten Abschnitts des Prüfzyklus den Kondensator 80 durch erneutes kontrolliertes Schließen des Systemschaltelementes 7 wieder auf eine gewünschte Kondensatorspannung U_{C} aufzuladen.

Ist der Kondensator 80 aufgeladen, wird in einem ersten Prüfschritt zunächst überprüft, ob das Systemschaltelement 7 ordnungsgemäß geöffnet hat. Dies wird durch Aufschalten einer Last auf den Kondensator 80 überprüft, wie in Fig. 2 dargestellt. Durch Schließen der Leistungsschalter 11 und 61 werden die Knotenpunkte W und V auf die Eingangsklemmen 3 und 5 geschaltet, so dass sich der Kondensator 80 über diese geschaltete elektrische Verbindung entladen kann, ohne dass sich der Rotor bewegt. Die Steuereinheit 70 überwacht die Kondensatorspannung U_{C} nach Schließen der Leistungsschalter 11 und 61; fällt die Kondensatorspannung U_{C} ab, geht also die Ladung im Kondensator 80 zurück, ist das Systemschaltelement 7 geöffnet. Das Systemschaltelement ist fehlerfrei und der Prüfzyklus kann fortgesetzt werden.

Bleibt hingegen die Kondensatorspannung U_{C} etwa konstant, ist dies ein Indiz dafür, dass das Systemschaltelement 7 nicht ordnungsgemäß geöffnet hat und die Anschlussklemme 93 weiterhin Verbindung mit dem Kondensator 80 hat. Der Kondensator 80 kann sich über die Spannungsquelle 90 auch bei Belastung durch die Statorwicklungen nicht entladen. Eine etwa konstante Kondensatorspannung U_{C} ist somit ein Indiz für einen Fehler im Systemschaltelement 7. Der Prüfzyklus wird abgebrochen und ein Fehler angezeigt.

Wird im ersten Prüfschritt bei der Belastung des Kondensators 80 mit einer Last eine sinkende Kondensatorspannung festgestellt, ist das Systemschaltelement fehlerfrei und ein nächster Prüfschritt wird eingeleitet. Dieser nächste Prüfschritt ist in Fig. 3 dargestellt.

Die Steuereinheit 70 überwacht weiterhin die Kondensatorspannung U_{C} und schließt - nacheinander oder gleichzeitig - die mit einer Eingangsklemme 5 verbundenen Leistungsschalter, im Ausfiihrungsbeispiel nach Fig. 3 alle Low-Side-Leistungsschalter 41, 51 und 61. Die High-Side-Leistungsschalter 11, 21 und 31 sind hingegen offen geschaltet. Ändert sich in diesem Schaltzustand die Kondensatorspannung U_{C} nicht, haben die High-Side-Leistungsschalter 11, 21 und 31 ordnungsgemäß geöffnet. Sinkt hingegen die Kondensatorspannung U_{C}, ist einer der Leistungsschalter 11, 21 oder 31 der High-Side defekt, da im Öffnungszustand ein unzulässiger Strom fließt.

Da es in diesem Prüfschritt nur darauf ankommt festzustellen, ob alle Leistungsschalter der High-Side 11, 21 und 31 funktionsgemäß öffnen, kann der Prüfschritt durch gleichzeitiges Schließen aller Low-Side-Leistungsschalter 41, 51 und 61 ausgeführt werden. Bei Absinken der Kondensatorspannung kann dann darauf geschlossen werden, dass einer der High-Side-Leistungsschalter defekt ist. Soll festgestellt werden, welcher der High-Side-Leistungsschalter defekt ist, kann jeweils nur ein Leistungsschalter der Low-Side in einem Zweig 17, 18, 19 geschlossen werden; fließt ein Strom und sinkt daher die Kondensatorspannung, ist der im gleichen Zweig 17, 18, 19 liegende offene Leistungsschalter der High-Side defekt. Dadurch ist eine Detektion des defekten Leistungsschalters möglich.

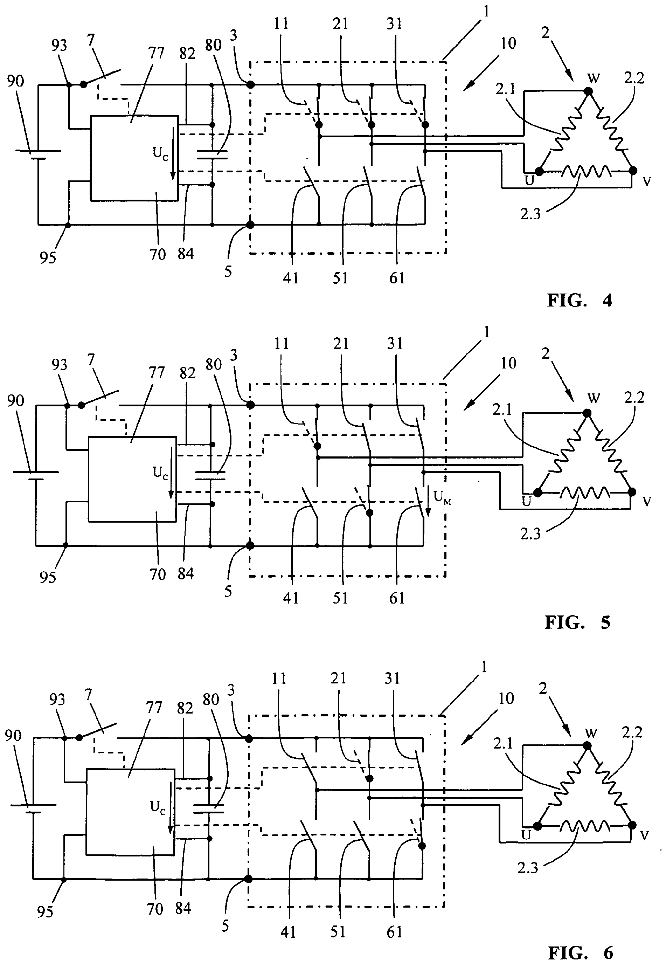

Im Ausfiihrungsbeispiel nach Fig. 4 wird dann entsprechend dem Ausführungsbeispiel nach Fig. 3 getestet, ob die Low-Side-Leistungsschalter 41, 51 und 61 ordnungsgemäß öffnen. Hierzu werden die High-Side-Leistungsschalter 11, 21, 31 geschlossen und bei sinkender Kondensatorspannung festgestellt, dass zumindest ein Low-Side-Leistungsschalter Durchgang hat, obwohl er offen geschaltet ist. Das Ergebnis wird als fehlerhaft bewertet und entsprechend angezeigt. Bleibt die Kondensatorspannung U_{C} hingegen weitgehend konstant, haben alle drei Low-Side-Leistungsschalter 41, 51, 61 ordnungsgemäß geöffnet. Der Prüfschritt ist fehlerfrei beendet.

Nachdem nun einerseits das ordnungsgemäße Öffnen des Systemschaltelementes 7 und andererseits das ordnungsgemäße Öffnen der Leistungsschalter 11, 21, 31, 41, 51 und 61 festgestellt wurde, könnte die Schaltungsanordnung 10 in Betrieb genommen werden. Die Elektronik der Schaltungsanordnung 10, nämlich das Systemschaltelement 7 und die Leistungsschalter 11 bis 61, öffnen ordnungsgemäß.

Vorteilhaft wird in einem erweiterten Prüfzyklus auch festgestellt, ob die Statorwicklungen 2.1, 2.2 und 2.3 ordnungsgemäß angeschlossen sind, keine Kurzschlüsse untereinander haben oder sonst wie defekt sind. Hierzu wird entsprechend den Prüfschritten der Figuren 5 bis 10 jede einzelne Schaltstellung eines Betriebszustands der Ansteuerschaltung 1 durchgeprüft. Im gezeigten Ausführungsbeispiel sind dies sechs Schaltstellungen, entsprechend der Weiterschaltung des Drehfeldes bei einem elektronisch kommutierten Motor in 60°-Schritten.

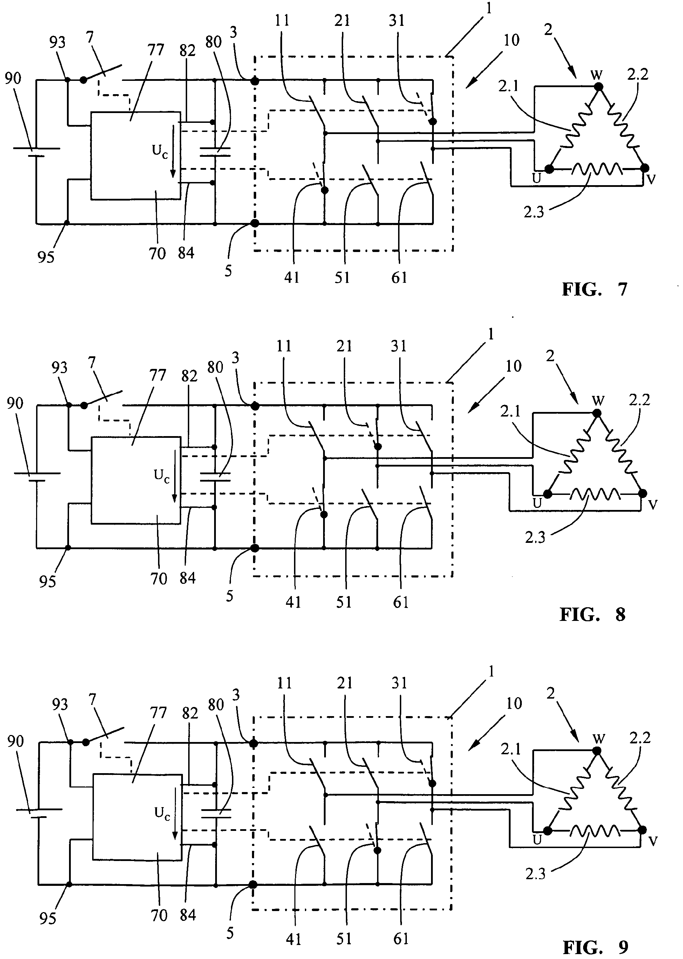

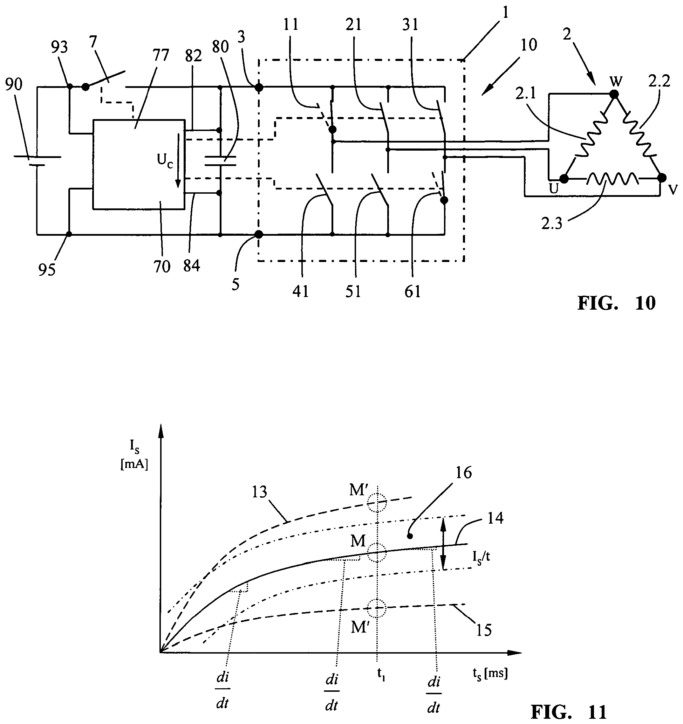

In Fig. 5 werden die Leistungsschalter 11 und 51 geschlossen, wodurch die Kondensatorspannung zwischen den Knotenpunkten W und U anliegt. In Fig. 6 liegt die Kondensatorspannung zwischen den Knotenpunkten U und V. In Fig. 7 liegt die Kondensatorspannung zwischen den Knotenpunkten V und W. In Fig. 8 liegt die Kondensatorspannung zwischen den Knotenpunkten U und W. In Fig. 9 liegt die Kondensatorspannung zwischen den Knotenpunkten V und U und in Fig. 10 liegt die Kondensatorspannung zwischen den Knotenpunkten W und V.

Um festzustellen, ob eine ordnungsgemäße Konnektierung einer Statorwicklung 2.1, 2.2 bzw. 2.3 vorliegt, wird der Anstieg des Spulenstroms I_{S} gemessen, was in Fig. 11 schematisch dargestellt ist. Die Erfassung des Spulenstroms I_{S} ist in einfacher Weise möglich über die Auswertung der über den Innenwiderstand eines geschlossenen Leistungsschalters abfallenden Spannung U_{M}, wie in Fig.1 oder 5 am Beispiel des Leistungsschalters 61 gezeigt ist. In gleicher Weise kann der Spulenstrom I_{S} über der Zeit t durch Abgriff der Spannung U_{A} an einem Shunt-Widerstand 87 bzw. 87' (Fig. 1) berechnet werden.

Sobald die Leistungsschalter zur Bestromung eines Knotenpaares geschlossen sind, wird sich - sofern die Leistungsschalter ordnungsgemäß schließen - ein Strom aufbauen entsprechend einer Kurve 14, wie sie in Fig. 11 schematisch dargestellt ist. Dabei ist die Bestromung so ausgebildet, dass sich der Rotor nicht bewegt; der Rotor steht. Liegt der erfasste Verlauf der Kurve 14, also der Stromanstieg, innerhalb eines vorgegebenen Korridors 16, liegt ein ordnungsgemäßer Zustand vor; die entsprechende Betriebsstellung der Ansteuerschaltung 1 arbeitet fehlerfrei. Ist hingegen die Kurve zu flach, wie am Beispiel der Kurve 15 dargestellt, oder zu steil, wie am Beispiel der Kurve 13 dargestellt, wird sie den Korridor 16 verlassen, und die Steuereinheit 70 kann einen fehlerbehafteten Zustand erkennen. In einfacher Weise kann zu einem Zeitpunkt t₁ der Momentanwert M festgestellt werden. Liegt der Momentanwert innerhalb des Korridors 16, arbeitet das System fehlerfrei; liegt der Momentanwert M' außerhalb des Korridors 16, ist der Arbeitszustand fehlerbehaftet.

Alternativ ist als Prüfschritt eine Ermittlung der Induktivität L der bestromten Statorwicklungen 2.1, 2.2 oder 2.3 durch Messung des Stromanstiegs di über der Zeit dt möglich. Nach der Gleichung L = U_{L} di/dt ist die jeweilige Induktivität zwischen den Kontenpunkten V, U und W einfach ermittelbar um festzustellen, ob ordnungsgemäße Betriebszustände vorliegen. Wird während einer Bestromung zwischen Knotenpunkten der sich ausbildende Stromanstieg mehrfach bestimmt, kann aus den erhaltenen Werten eine mittlere Induktivität berechnet werden, so dass ein eventuelle Offset Einfluss eliminiert werden kann.

Da im Verlauf der verschiedenen Prüfschritte aus dem Kondensator 80 Energie abgezogen wird, fällt dessen Spannung U_{C} ab; um bei der Prüfung der Induktivität L zwischen den jeweiligen Knotenpunkten eine immer gleiche Prüfspannung aufzuschalten, ist vorgesehen, aus der Kondensatorspannung U_{C} ein pulsweitenmoduliertes Signal als Prüfspannung abzuleiten, wobei die Pulsweite abhängig von der Kondensatorspannung U_{C} derart eingestellt ist, dass eine immer gleiche mittlere effektive Prüfspannung gegeben ist. Unabhängig vom Ladezustand des Kondensators 80 kann so eine gleichbleibende effektive Prüfspannung bereit gestellt werden.

In den gezeigten Ausfiihrungsbeispielen sind das Systemschaltelement und die Leistungsschalter 11 bis 61 schematisch dargestellt. Zweckmäßig sind diese Elemente elektronische Schaltelemente, insbesondere MOSFET's, Thyristoren oder dgl..

Der Kondensator 80 ist zweckmäßig so ausgelegt, dass eine vollständige Ladung des Kondensators ausreichend ist, um sowohl die für einen Grundzyklus erforderliche Energie als auch die für den erweiterten Prüfzyklus erforderliche Energie zur Verfügung zu stellen. Die Energie des geladenen Kondensators ist auch deswegen ausreichend, da ein einzelner Prüfschritt nur im Bereich von Millisekunden liegt, vorzugsweise im Bereich von 1 bis 10 Millisekunden. Aufgrund dieser kurzen Zeiträume ist auch gewährleistet, dass sich während des Prüfzyklus der Rotor des Motors nicht dreht. Alle einzelnen Prüfschritte erfolgen somit bei stehendem Rotor.

Die Energie des Kondensators 80 ist auch deswegen ausreichend, weil in jedem Prüfschritt des Prüfzyklus die Kondensatorspannung U_{C} zweckmäßig als pulsweitenmodulierte Prüfspannung eingespeist wird, so dass die Ströme und Spannungen in jedem Prüfschritt vorgegeben bzw. eingestellt werden können.

## Patentansprüche

1. Verfahren zur Inbetriebnahme einer elektronischen Ansteuerschaltung (1) für die Wicklungen (2.1, 2.2, 2.3) eines elektrischen Motors (2),
∘ mit einer an eine Spannungsquelle (90) angeschlossenen Steuereinheit (70),
∘ mit einem über ein Systemschaltelement (7) mit den Anschlussklemmen (93, 95) der Spannungsquelle (90) verbundenen Kondensator (80),
∘ wobei der Kondensator (80) an den Eingangsklemmen (3, 5) parallel zur Ansteuerschaltung (1) liegt,
∘ und mit einer Betriebsschaltung (77) für das Systemschaltelement (7),
∘ wobei vor der Inbetriebnahme des Motors (2) das Systemschaltelement (7) geschlossen und der Kondensator (80) geladen wird,
∘ und wobei nach dem Laden des Kondensators (80) das Systemschaltelement (7) geöffnet wird,
∘ und die Steuereinheit (70) einen Prüfschritt für die Ansteuerschaltung (1) startet,
∘ und wobei **während des Prüfschrittes** das Systemschaltelement (7) geöffnet ist und die Ansteuerschaltung (1) ausschließlich von der Kondensatorspannung (Uc) des geladenen Kondensators (80) gespeist wird.

2. Verfahren nach Anspruch 1,
wobei die Kondensatorspannung (Uc) von der Steuereinheit (70) überwacht wird und anhand einer Änderung der Kondensatorspannung (Uc) während eines Prüfschrittes des Prüfzyklus in Abhängigkeit des durchgeführten Prüfschrittes die Entscheidung gefällt wird, ob der durchgeführte Prüfschritt des Prüfzyklus fehlerfrei oder fehlerbehaftet ist.

3. Verfahren nach Anspruch 2,
wobei nach dem Öffnen des Systemschaltelementes (7) in einem Prüfschritt der Kondensator (80) mit einer Last verbunden wird und bei sinkender Kondensatorspannung (Uc) das Systemschaltelement (7) als fehlerfrei und bei etwa konstanter Kondensatorspannung (Uc) das Systemschaltelement (7) als fehlerbehaftet bewertet wird.

4. Verfahren nach Anspruch 2 oder 3,
wobei die Ansteuerschaltung (1) die Spulenenden der Wicklungen (2.1, 2.2, 2.3) über je einen Leistungsschalter (11, 21, 31) mit der einen, ersten Anschlussklemme (93) der Spannungsquelle (90) und über je einen weiteren Leistungsschalter (41, 51, 61) mit der anderen, zweiten Anschlussklemme (95) verbindet, und dass in einem Prüfschritt mindestens ein an der ersten Anschlussklemme (93) angeschlossener Leistungsschalter (11, 21, 31) geschlossen wird und alle mit der zweiten Anschlussklemme (95) verbundenen Leistungsschalter (41, 51, 61) offen gehalten werden und die Kondensatorspannung (Uc) ausgewertet wird.

5. Verfahren nach Anspruch 4,
wobei bei sinkender Kondensatorspannung (Uc) zumindest einer der an die zweite Anschlussklemme (95) angeschlossenen Leistungsschalter (41, 51, 61) als fehlerbehaftet bewertet wird und bei etwa konstanter Kondensatorspannung (Uc) die an die zweite Anschlussklemme (95) angeschlossenen Leistungsschalter (41, 51, 61) als fehlerfrei bewertet werden.

6. Verfahren nach Anspruch 4 oder 5,
wobei alle an der einen, ersten Anschlussklemme (93) angeschlossenen Leistungsschalter (11, 21, 31) in dem Prüfschritt gleichzeitig geschlossen werden.

7. Verfahren nach einem der Ansprüche 1 bis 6,
wobei in einem Prüfschritt eine aus der Kondensatorspannung (Uc) abgeleitete Prüfspannung auf eine Wicklung (2.1, 2.2, 2.3) aufgeschaltet wird und der bei stehendem Rotor über der Zeit (t) anwachsende Strom (I_{S}) gemessen und von der Steuereinheit (70) ausgewertet wird.

8. Verfahren nach Anspruch 7,
wobei der Stromanstieg (di/dt) über der Zeit ermittelt und nach der Gleichung L=U_{L}^{∗}di/dt die Induktivität berechnet wird.

9. Verfahren nach Anspruch 8,
wobei während der Bestromung mehrfach der Stromanstieg (di/dt) ermittelt und die Induktivität (L) berechnet wird und ein Mittelwert der Induktivität bestimmt wird.

10. Verfahren nach Anspruch 7,
wobei bei einer Lage der Stromkurve (14) innerhalb eines vorgegebenen Korridors (16) die Wicklung (2.1, 2.2, 2.3) als fehlerfrei und bei einer Lage der Stromkurve (13, 15) außerhalb des vorgegebenen Korridors (16) die Wicklung (2.1, 2.2, 2.3) als fehlerhaft bewertet wird.

11. Verfahren nach Anspruch 7,
wobei die Prüfspannung ein aus der Kondensatorspannung (Uc) abgeleitetes pulsweitenmoduliertes Signal ist.

12. Verfahren nach den Ansprüchen 1 bis 11,
wobei ein Prüfzyklus aus mehreren Prüfschritten besteht, wobei in einem ersten Prüfschritt die Funktion des Systemschaltelementes (7), in einem zweiten Prüfschritt der Masseschluss eines Leistungsschalters (11, 21, 31, 41, 51, 61) und in einem dritten Prüfschritt der ordnungsgemäße Anschluss der Wicklungen (2.1, 2.2, 2.3) geprüft wird.

13. Verfahren nach einem der Ansprüche 1 bis 12,
wobei die Steuereinheit (70) vor dem Schließen des Systemschaltelementes (7) die Ansteuerschaltung (1) in eine definierte Ausgangsstellung schaltet.

## Claims

1. Method for starting an electronic control circuit (1) for the windings (2.1, 2.2, 2.3) of an electric motor (2),
∘ having a control unit (70) connected to a voltage source (90),
∘ having a capacitor (80) connected to the connecting terminals (93, 95) of the voltage source (90) via a system switch element (7),
∘ wherein the capacitor (80) lies on the input terminals (3, 5) parallel to the control circuit (1),
∘ and having an operating circuit (77) for the system switch element (7),
∘ wherein, before the motor (2) is started, the system switch element (7) is closed and the capacitor (80) is charged,
∘ and wherein, after the capacitor (80) has been charged, the system switch element (7) is opened,
∘ and the control unit (70) starts a test step for the control circuit (1)
∘ and wherein, during the test step, the system switch element (7) is open and the control circuit (1) is fed only by the capacitor voltage (UC) of the charged capacitor (80).

2. Method according to Claim 1,
wherein the capacitor voltage (UC) is monitored by the control unit (70) and on the basis of a change in the capacitor voltage (UC) during a test step of the test cycle, depending on the test step carried out, the decision is made as to whether the carried-out test step of the test cycle is fault free or has faults.

3. Method according to Claim 2,
wherein, after the system switch element (7) has been opened in a test step, the capacitor (80) is connected to a load and if the capacitor voltage (UC) drops, the system switch element (7) is assessed as being fault free, and if the capacitor voltage (UC) is approximately constant, the system switch element (7) is assessed as having faults.

4. Method according to Claim 2 or 3,
wherein the control circuit (1) connects the coil ends of the windings (2.1, 2.2, 2.3) via a respective power switch (11, 21, 31) to the one, first connecting terminal (93) of the voltage source (90) and via a respective further power switch (41, 51, 61) to the other, second connecting terminal (95), and wherein, in a test step, at least one power switch (11, 21, 31) connected to the first connecting terminal (93) is closed and all of the power switches (41, 51, 61) connected to the second connecting terminal (95) are kept open and the capacitor voltage (UC) is evaluated.

5. Method according to Claim 4,
wherein, if the capacitor voltage (UC) drops, at least one of the power switches (41, 51, 61) connected to the second connecting terminal (95) is assessed as having faults, and if the capacitor voltage (UC) is approximately constant, the power switches (41, 51, 61) connected to the second connecting terminal (95) are assessed as being fault free.

6. Method according to Claim 4 or 5,
wherein all of the power switches (11, 21, 31) connected to the one, first connecting terminal (93) are closed simultaneously in the test step.

7. Method according to one of Claims 1 to 6,
wherein, in a test step, a test voltage derived from the capacitor voltage (UC) is applied to a winding (2.1, 2.2, 2.3) and the current (IS) which increases over time (t) with the rotor at a standstill is measured and evaluated by the control unit (70).

8. Method according to Claim 7,
wherein the current increase (di/dt) over time is determined and the inductivity is calculated according to the equation L=UL*di/dt.

9. Method according to Claim 8,
wherein, while current is flowing, the current increase (di/dt) is determined and the inductivity (L) calculated multiple times and an average of the inductivity is determined.

10. Method according to Claim 7,
wherein, if the current curve (14) lies within a predetermined corridor (16), the winding (2.1, 2.2, 2.3) is assessed as being fault free, and if the current curve (13, 15) lies outside the predetermined corridor (16), the winding (2.1, 2.2, 2.3) is assessed as having faults.

11. Method according to Claim 7,
wherein the test voltage is a pulse-width modulated signal derived from the capacitor voltage (UC).

12. Method according to Claims 1 to 11,
wherein a test cycle consists of multiple test steps, wherein, in a first test step, the function of the system switch element (7) is tested, in a second test step, the short-circuit to earth of a power switch (11, 21, 31, 41, 51, 61) is tested, and in a third test step, the proper connection of the windings (2.1, 2.2, 2.3) is tested.

13. Method according to one of Claims 1 to 12,
wherein the control unit (70) switches the control circuit (1) into a defined starting position before the system switch element (7) is closed.

## Revendications

1. Procédé de mise en service d'un circuit de commande électronique (1) destiné à des enroulements (2.1, 2.2, 2.3) d'un moteur électrique (2) et comprenant
∘ une unité de commande (70) raccordée à une source de tension (90),
∘ un condensateur (80) relié aux bornes (93, 95) de la source de tension (90) par le biais d'un élément de commutation de système (7),
∘ le condensateur (80) étant situé au niveau des bornes d'entrée (3, 5) parallèlement au circuit de commande (1),
∘ et un circuit d'exploitation (77) destiné à l'élément de commutation de système (7),
∘ l'élément de commutation de système (7) étant fermé, et le condensateur (80) étant chargé, avant le démarrage du moteur (2),
∘ et l'élément de commutation de système (7) étant ouvert après que le condensateur (80) a été chargé,
∘ et l'unité de commande (70) lançant une étape de test du circuit de commande (1),
∘ et l'élément de commutation de système (7) étant ouvert, et le circuit de commande (1) étant alimenté exclusivement par la tension de condensateur (UC) du condensateur chargé (80), pendant l'étape de test.

2. Procédé selon la revendication 1,
la tension de condensateur (UC) étant surveillée par l'unité de commande (70) et, sur la base d'une variation de la tension de condensateur (UC) pendant une étape de test, une décision étant prise en fonction de l'étape de test exécutée sur le fait que l'étape de test exécutée est exempte d'erreurs ou comporte des erreurs.

3. Procédé selon la revendication 2,
après l'ouverture de l'élément de commutation de système (7), le condensateur (80) étant relié à une charge dans une étape de test et, si la tension de condensateur (UC) chute, l'élément de commutation de système (7) étant évalué comme non-défectueux et, si la tension de condensateur (UC) est à peu près constante, l'élément de commutation de système (7) étant évalué comme défectueux.

4. Procédé selon la revendication 2 ou 3,
le circuit de commande (1) reliant les extrémités de bobine des enroulements (2.1, 2.2, 2.3) à la première borne de raccordement (93) de la source de tension (90) par le biais d'un commutateur de puissance respectif (11, 21, 31) et à l'autre deuxième borne de raccordement (95) par le biais d'un commutateur d'alimentation supplémentaire respectif (41, 51, 61), et au moins un commutateur de puissance (11, 21, 31) relié à la première borne de raccordement (93) étant fermé, et tous les commutateurs de puissance (41, 51, 61) reliés à la deuxième borne de raccordement (95) étant maintenus ouverts et la tension de condensateur (UC) étant évaluée, dans une étape de test.

5. Procédé selon la revendication 4,
si la tension de condensateur (UC) chute, au moins un des commutateurs de puissance (41, 51, 61) reliés à la deuxième borne de raccordement (95) étant évalué comme défectueux et, si la tension de condensateur (UC) est à peu près constante, les commutateurs de puissance (41, 51, 61) reliés à la deuxième borne de raccordement (95) pouvant être évalués comme non-défectueux.

6. Procédé selon la revendication 4 ou 5,
tous les commutateurs de puissance (11, 21, 31) raccordés à une première borne de raccordement (93) étant fermés simultanément à l'étape de test.

7. Procédé selon l'une des revendications 1 à 6,
dans une étape de test, une tension de test dérivée de la tension de condensateur (UC) étant appliquée à un enroulement (2.1, 2.2, 2.3) et le courant (IS), qui augmente avec le temps (t) lorsque le rotor est à l'arrêt, étant mesuré et évalué par l'unité de commande (70).

8. Procédé selon la revendication 7,
l'augmentation de courant (di/dt) dans le temps étant déterminée et l'inductance étant calculée selon l'équation L=UL*di/dt.

9. Procédé selon la revendication 8,
l'augmentation de courant (di/dt) étant déterminée, et l'inductance (L) étant calculée et une valeur moyenne de l'inductance étant déterminée, plusieurs fois pendant l'alimentation en courant.

10. Procédé selon la revendication 7,
lorsque la courbe de courant (14) est située à l'intérieur d'un couloir spécifié (16), l'enroulement (2.1, 2.2, 2.3) étant évalué comme non-défectueux et, lorsque la courbe de courant (13, 15) est située à l'extérieur du couloir spécifié (16), l'enroulement (2.1, 2.2, 2.3) évalué comme défectueux.

11. Procédé selon la revendication 7,
la tension de test étant un signal modulé en largeur d'impulsion dérivé de la tension de condensateur (UC).

12. Procédé selon les revendications 1 à 11,
un cycle de test comprenant plusieurs étapes de test, la fonction de l'élément de commutation de système (7) étant vérifiée dans une première étape de test, la connexion à la terre d'un commutateur de puissance (11, 21, 31, 41, 51, 61) étant vérifiée dans une deuxième étape de test, et la connexion correcte des enroulements (2.1, 2.2, 2.3) étant vérifiée dans une troisième étape de test.

13. Procédé selon l'une des revendications 1 à 12,
l'unité de commande (70) commutant le circuit de commande (1) dans une position initiale définie avant la fermeture de l'élément de commutation de système (7).
